# EUROPEAN PATENT APPLICATION

(11) **EP 1 626 358 A2**
(43) Date of publication of application: **15.02.2006**
(21) Application number: 04257100.0
(22) Date of filing: 16.11.2004
(51) Int. Cl.: G06F 17/50, G06T 17/20

(54) **Contact definition device, program, and method**

(30) Priority: 09.08.2004 JP 2004232114
(71) Applicant: FUJITSU LIMITED, Kawasaki-shi, Kanagawa 211-8588 (JP)
(72) Inventor: Imai, Kanako, c/o Fujitsu Limited, Kawasaki-shi, Kanagawa 211-8588 (JP)
(74) Representative: Stebbing, Timothy Charles

(57) **Abstract**

Definition of pairs of faces having the possibility of being in mutual contact among a plurality of objects is performed accurately and efficiently. A contact definition device (1) comprises a shape data acquisition portion (15), which acquires data relating to the surface shapes of a plurality of objects; a positional relation information acquisition portion (16), which acquires positional relation information relating to prescribed positional relations among the plurality of objects; a vector information acquisition portion (12), which acquires information related to a normal vector in an arbitrary region at the outer surface of an arbitrary object, among the plurality of objects, directed outward from the object; and, a contact definition portion (14) which defines, based on the data relating to surface shapes, positional relation information and information relating to normal vectors, a region closest to the arbitrary region among the regions of the outer surfaces of other objects having normal vectors in substantially the opposite direction of the normal vector positioned in the direction of the normal vector in the arbitrary region of the outer surface of the arbitrary object in the above prescribed positional relations, as a region which can be in contact with the arbitrary region.

## Description

This invention relates to a contact definition device, contact definition program, and contact definition method, which define contact between a plurality of objects.

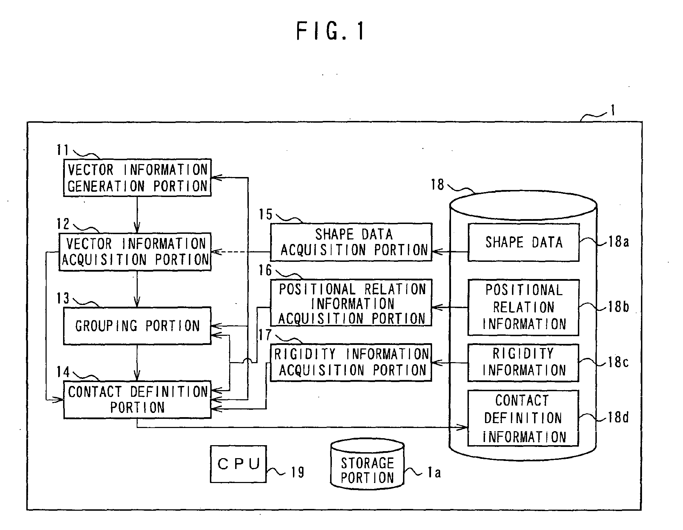

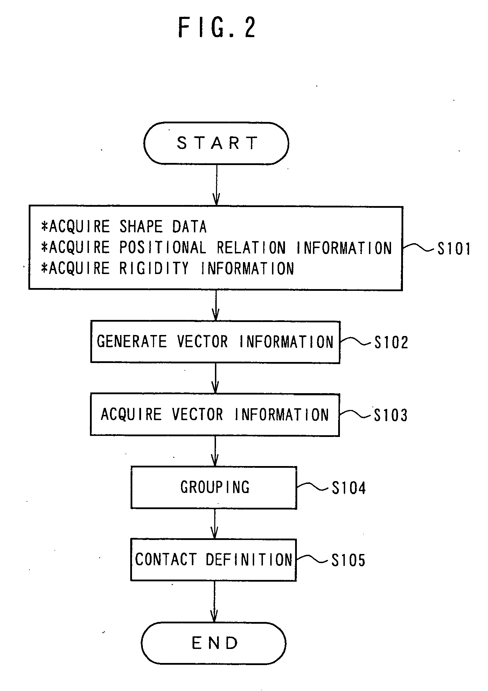

In the prior art, technology has been provided for analysis of the deformation and motion of objects accompanying contact, using the finite element method and other means (see for example Japanese Patent Laid-open No. 9-145493 (pages 4 through 8, Fig. 2), Japanese Patent Laid-open No. 2001-337940 (pages 5 through 10, Fig. 1), and Japanese Patent Laid-open No. 2002-56037 (pages 3 and 4, Fig. 1)).

In the above technology of the prior art, the user confirms objects for which there is a possibility of contact based on shape data for the objects, and pairs of faces at which mutual contact between objects is possible (so-called contact pairs) are selected manually by the user, and the pair of selected faces is defined as a contact pair.

However, the above-described manual operation becomes troublesome when the number of objects to be analyzed increases, or the number of places of contact between objects is large, and errors tend to occur easily in the selection of faces for which contact is possible and in definitions of contact pairs. Such errors can be identified manually by a user, but are often discovered for the first time when data for which definitions have been performed is actually analyzed.

The occurrence of the above-described contact pair definition errors leads to increases in the number of error debugging and other processes, and impedes the improvement of operation efficiency.

This invention was made in view of the above-described problems, in particular the need for accurate and efficient definition of pairs of faces between which mutual contact is possible among a plurality of objects.

A contact definition device of this invention is characterized in comprising a shape data acquisition portion, which acquires data relating to the surface shapes of a plurality of objects; a positional relation information acquisition portion, which acquires positional relation information relating to prescribed positional relations among the above plurality of objects; a vector information acquisition portion, which acquires information related to the normal vector in an arbitrary region at the outer surface of an arbitrary object, among the above plurality of objects, directed outward from the object; and, a contact definition portion which defines, based on the above data relating to surface shapes, positional relation information and information relating to normal vectors, the region closest to the arbitrary region among the regions of the outer surfaces of other objects having normal vectors in substantially the opposite direction of the normal vector positioned in the direction of the above normal vector in the arbitrary region of the outer surface of an arbitrary object in the above prescribed positional relations, as a region which can be in contact with the arbitrary region. By means of this configuration, definition of pairs of faces which can be in mutual contact among a plurality of objects, which had in the prior art been performed by manual operations, can be performed accurately and efficiently by automated means.

In a contact definition device with the above-described configuration, it is preferable that data relating to the surface shapes of the above objects comprise data for a plurality of face elements, that the contact definition device further comprises a grouping portion which, based on the above data relating to surface shapes, groups a plurality of face elements existing in the same plane on the same object, and that the above contact definition portion performs the above definition for each region of the above groups of grouped face elements. By thus defining contact pairs for groups of grouped face elements, the processing load can be greatly alleviated compared with a case in which definition of contact pairs is performed for individual face elements.

In a contact definition device with the above configuration, the above grouping portion can be configured to perform grouping of face elements orthogonal to a prescribed coordinate axis, based on the orthogonal coordinate axis, the coordinates of the face elements, and the normal vectors of the face elements. In general, a face element characterized by data relating to the surface shape of an object is often orthogonal to a coordinate axis (for example, one of the coordinate axes in an X-Y-Z coordinate system); by performing grouping based on the orthogonal coordinate axis, the coordinates of the face element and the direction of the normal vector to the face element, efficient processing can be performed to define contact between face groups with a high possibility of being contact pairs.

Further, a contact definition program of this invention is characterized in causing a computer program to execute a shape data acquisition step to acquire data relating to the surface shapes of a plurality of objects; a positional relation information acquisition step to acquire positional relation information relating to prescribed positional relations among the above plurality of objects; a vector information acquisition step to acquire information related to the normal vector in an arbitrary region at the outer surface of an arbitrary object, among the above plurality of objects, directed outward from the object; and, a contact definition step to define, based on the above data relating to surface shapes, positional relation information and information relating to normal vectors, the region closest to the arbitrary region among the regions of the outer surfaces of other objects having normal vectors in substantially the opposite direction of the normal vector positioned in the direction of the above normal vector in the arbitrary region of the outer surface of the arbitrary object in the above prescribed positional relations, as a region which can be in contact with the arbitrary region.

Further, a contact definition method of this invention is characterized in having a shape data acquisition step to acquire data relating to the surface shapes of a plurality of objects; a positional relation information acquisition step to acquire positional relation information relating to prescribed positional relations among the above plurality of objects; a vector information acquisition step to acquire information related to the normal vector in an arbitrary region at the outer surface of an arbitrary object, among the above plurality of objects, directed outward from the object; and, a contact definition step to define, based on the above data relating to surface shapes, positional relation information and information relating to normal vectors, the region closest to the arbitrary region among the regions of the outer surfaces of other objects having normal vectors in substantially the opposite direction of the normal vector positioned in the direction of the above normal vector in the arbitrary region of the outer surface of the arbitrary object in the above prescribed positional relations, as a region which can be in contact with the arbitrary region.

By means of the invention described in detail above, pairs of faces which can be in mutual contact among a plurality of objects can be defined accurately and efficiently.

Reference will now be made, by way of example only, to the accompanying drawings in which:
Fig. 1 is a functional block diagram showing the overall configuration of a contact definition device of an aspect of the invention;
Fig. 2 is a flowchart showing the flow of processing in the contact definition device of the aspect;
Fig. 3 is a drawing showing a component A, component B, and component C, as examples of a plurality of objects for contact definition;
Fig. 4 is a drawing showing a state in which component A, component B, and component C are assembled;
Fig. 5 is a flowchart showing the flow of specific processing of contact definition, using input data for analysis, of the aspect;
Fig. 6 is a flowchart used to explain the reading of an input file for analysis;
Fig. 7 shows an example of the configuration of a data array in the array NODE;
Fig. 8 shows an example of the configuration of a data array in the array ELEM;
Fig. 9 is a flowchart used to explain extraction of the outer surface shape of each component;
Fig. 10 shows an example of the configuration of a data array in the array FACEA;
Fig. 11 is a drawing used to explain a method of definition of the order of nodes in a hexahedron (rectangular parallelepiped);
Fig. 12 is a drawing used to explain a method of definition of the order of nodes in a pentahedron (triangular prism);
Fig. 13 is a drawing used to explain a method of definition of the order of nodes;
Fig. 14 shows an example of the configuration of a data array in the array FACE;
Fig. 15 shows an example of the configuration of a data array in the array KT3;
Fig. 16 is a flowchart used to explain the classification of face groups;
Fig. 17 shows an example of the configuration of a data array in the array MENNO;
Fig. 18 shows an example of the configuration of a data array in the array FACEB;
Fig. 19 shows the manner of division into groups of each face element comprised by the components A through C;
Fig. 20 is a flowchart used to explain the creation of free edges in the respective face groups;
Fig. 21 shows an example of the configuration of a data array in the array EDGE;
Fig. 22 shows an example of the configuration of a data array in the array EDGEA;
Fig. 23 is a flowchart used to explain the extraction of closed edge regions in the respective face groups;
Fig. 24 is a flowchart used to explain the extraction of closed edge regions in the respective face groups;
Fig. 25 shows an example of the configuration of a data array in the array MINMAX;
Fig. 26 shows an example of the configuration of a data array in the array EDGEB;
Fig. 27 shows an example of an extracted closed edge region;
Fig. 28 is a flowchart used to explain the definition of contact pairs between face groups;
Fig. 29 is a flowchart used to explain the definition of contact pairs between face groups;
Fig. 30 shows an example of the configuration of a data array in the array AREA;
Fig. 31 shows an example of the configuration of a data array in the array FACED;
Fig. 32 shows an example of the configuration of a data array in the array CPAIR; and,
Fig. 33 is a table showing an example of list output of information related to contact pairs.

Below, aspects of the invention are explained, referring to the drawings.

Fig. 1 is a functional block diagram showing the overall configuration of a contact definition device of an aspect of the invention.
The contact definition device 1 of this aspect comprises a vector information generation portion 11, vector information acquisition portion 12, grouping portion 13, contact definition portion 14, shape data acquisition portion 15, positional relation information acquisition portion 16, rigidity information acquisition portion 17, database 18, CPU 19, and storage portion 1a.

The database 18 stores shape data 18a, which is data relating to the surface shapes of a plurality of objects; positional relation information 18b, which relates to prescribed positional relations among a plurality of objects; rigidity information 18c, which is data relating to the rigidity of a plurality of objects; and contact definition information 18d, which is definition information relating to contact among a plurality of objects.

The shape data acquisition portion 15 serves the purpose of acquiring shape data 18a which is stored in the database 18. Data relating to the surface shapes of the respective objects in the shape data 18a comprises data for a plurality of face elements.

The positional relation information acquisition portion 16 serves the purpose of acquiring positional relation information 18b which is stored in the database 18. The vector information generation portion 11 serves the purpose of generating information relating to a normal vector, directed outward from the object, in an arbitrary region of the outer surface of an arbitrary object among a plurality of objects, based on the shape data 18a.

The vector information acquisition portion 12 serves the purpose of acquiring information relating to the normal vectors generated by the vector information generation portion 11.

The grouping portion 13 serves the purpose of grouping a plurality of face elements existing in the same plane in the same object, based on the shape data 18a acquired by the shape data acquisition portion 15. Details of the grouping of a plurality of face elements are described below. The contact definition portion 14 performs, for each region of a group of face elements which have been grouped, definition (contact definition) of pairs of faces which have the possibility of being in mutual contact among a plurality of objects, based on shape data 18a, positional relation information 18b, and information relating to normal vectors. Information relating to contact definitions obtained by this contact definition is stored, as contact definition information 18d, in the database 18.

The rigidity information acquisition portion 17 serves the purpose of acquiring rigidity information 18c, which is stored in the database 18.

The storage portion 1a stores a plurality of data items, such as the array NODE, the array ELEM, the array FACEA, the array FACE, the array KT3, the variable KT1, the array MENNO, the array FACEB, the array EDGE, the array EDGEA, the variable ICMEN, the variable ICNODE, the array MINMAX, the array EDGEB, the array AREA, the array FACED, and the array CPAIR. These data items are described in detail below.

Here, an example is described in which the database 18 is positioned within the contact definition device 1, but this is not necessary, and for example the database 18 may be positioned in external equipment, connected via an electrical communication circuit to the contact definition device 1 so as to enable communication. Also, an example is described in which the data items from the shape data 18a to the contact definition information 18d are stored in a single database, but this is not necessary, and for example the various data items may be stored in storage areas of separate external equipment.

Next, operation of the contact definition device of this aspect is explained. Fig. 2 is a flowchart showing the flow of processing in the contact definition device of this aspect.

First, the shape data 18a, positional relation information 18b and rigidity information 18c are acquired from the database 18 (shape data acquisition step, positional relation information acquisition step, rigidity information acquisition step) (S101).

Next, based on the acquired shape data 18a, information is generated relating to the normal vector, directed outward from the object, in an arbitrary region of the outer surface of an arbitrary object among a plurality of objects (vector information generation step) (S102).

Then, information is acquired relating to the normal vector generated in the vector information generation step (vector information acquisition step) (S103).

Based on shape data 18a acquired in the above steps, grouping of a plurality of face elements existing in the same plane in the same object is performed (grouping step) (S104).

Then, for each region of a group of face elements which have been grouped, contact definition is performed based on the shape data 18a, positional relation information 18b, and information related to normal vectors (contact definition step) (S105). In the contact definition step, information related to contact definition is stored as contact definition information 18d. In this way, contact pairs are defined for groups of face elements which have been grouped, so that compared with definition of contact pairs for individual face elements, the processing load can be greatly alleviated.

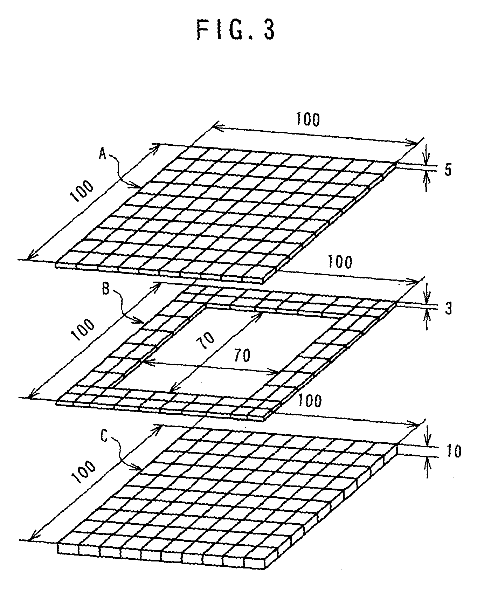

Below, this aspect is explained in detail while describing specific examples. Fig. 3 shows a component A, component B, and component C, as examples of a plurality of objects for contact definition.

Data relating to the surface shapes of component A, component B and component C shown in the drawing is, for example, input data for analysis obtained by the finite element method of analysis (equivalent to the shape data 18a, positional relation information 18b, and rigidity information 18c stored in the database 18). Each of these components is divided into a mesh, and comprises a plurality of elements. The regions of these elements are stipulated by a plurality of nodes. The input data for analysis has element numbers, the coordinates of nodes comprised by the respective elements, and information (such as rigidity) related to the material of the component.

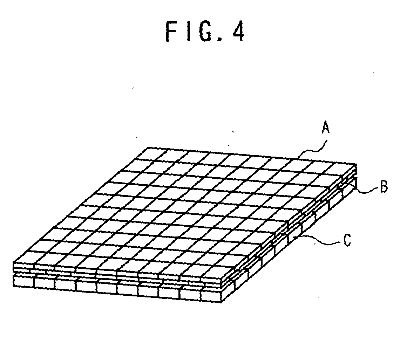

Here component A is sheet-shaped, measuring 100 mm x 100 mm x 5 mm; component B is sheet-shaped member measuring 100 mm x 100 mm x 3 mm, with a 70 mm x 70 mm hole formed; and component C is sheet-shaped, measuring 100 mm x 100 mm x 10 mm. These components A through C are stacked and assembled as shown in Fig. 4, and in the assembled state as shown in the drawing (that is, in the state in which the components are in a prescribed positional relation), when deformation and similar of the members upon receiving an external force or similar is considered, there may be the possibility that the bottom face of component A, the top face of component B, and the top face of component C, or the bottom face of component B and the top face of component C, may come into contact.

In the assembled state, in the above-described components A through C, node positions are provided such that nodes are not common to adjacent components.

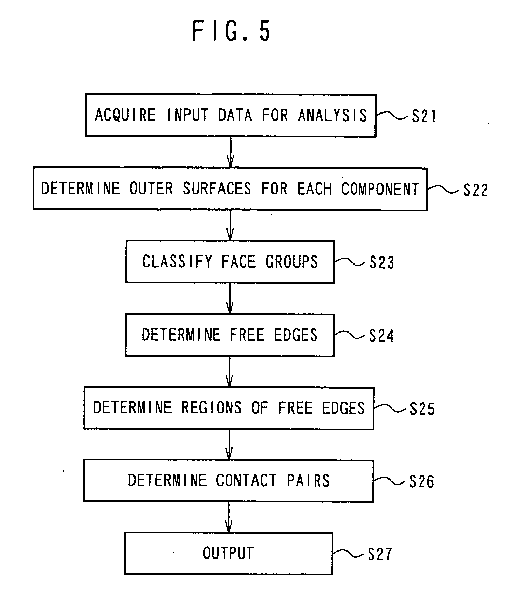

Fig. 5 is a flowchart showing the flow of specific processing of contact definition, using input data for analysis in this aspect. Processing for contact definition in this aspect comprises the steps of acquisition of the input data for analysis, as shown in the drawing (S21); extraction of outer surface shapes for each component (S22); classification of face groups (S23); free edge creation (S24); determination of free edge regions (S25); determination of contact pairs (S26); and output (S27).

Here, S21 is equivalent to a shape data acquisition step, positional relation information acquisition step, and rigidity information acquisition step; the processing in S21 is mainly realized in the shape data acquisition portion 15, positional relation information acquisition portion 16, and rigidity information acquisition portion 17.

S22 and S23 are equivalent to a vector information generation step, vector information acquisition step, and grouping step; the processing in S22 and S23 is mainly realized in the vector information generation portion 11, vector information acquisition portion 12, and grouping portion 13. S24 through S27 are equivalent to a contact definition step, and the processing in S24 through S27 is mainly realized in the contact definition portion 14 and using the contact definition information 18d. Below, these steps (S21 through S27) are explained in detail.

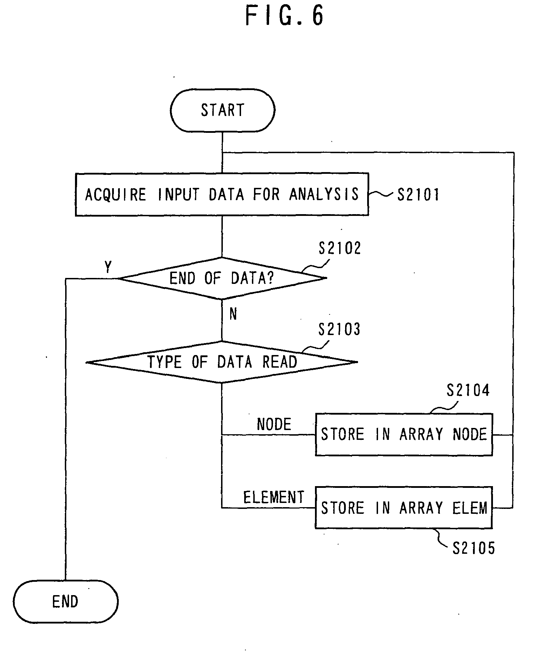

First, reading of input data for analysis (S21 in Fig. 5) is explained in detail using the flowchart of Fig. 6.

The input data for analysis for components A through C, stored in the database 18, is acquired (S2101).

When there is no data to be acquired (Yes in S2102), processing ends. When however there is data to be acquired (No in S2102), information on elements comprised by the acquired data and information on nodes comprised by these elements are discriminated (S2103), the node numbers and node coordinates for nodes comprised by each component are stored in the array NODE (S2104), and the elements numbers of elements stipulating surface shapes for each component, and the node numbers of nodes comprised by each element, are stored in the array ELEM (S2105). In this aspect, coordinate values of nodes and positional relations between objects are stipulated in an X-Y-Z coordinate system.

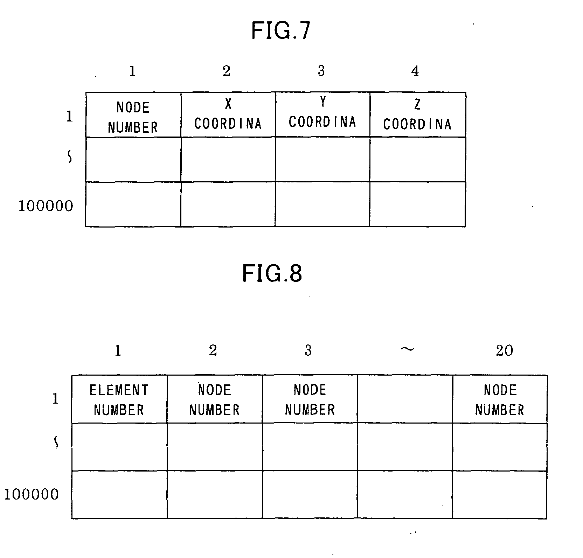

Fig. 7 shows an example of the configuration of a data array in the array NODE; Fig. 8 shows an example of the configuration of a data array in the array ELEM.

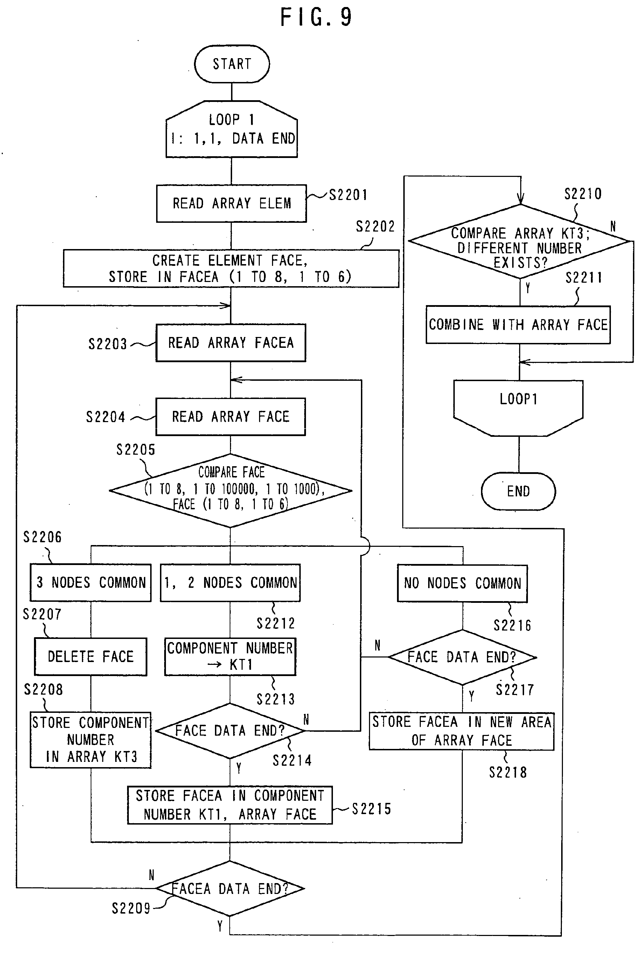

Next, the flowchart of Fig. 9 is used to explain extraction of the outer surface shape of each component (S22 in Fig. 5).

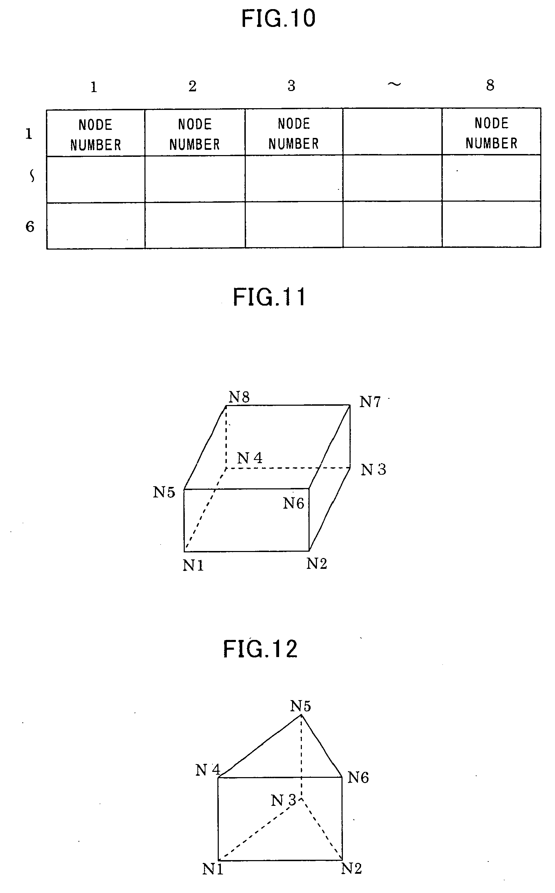

First, information for elements is read, one element's worth at a time, from the data array stored in the above-described array ELEM (S2201), face elements are created, and node numbers comprised by face elements are stored for each face element in the array FACEA (S2202). Fig. 10 shows an example of the configuration of a data array in the array FACEA.

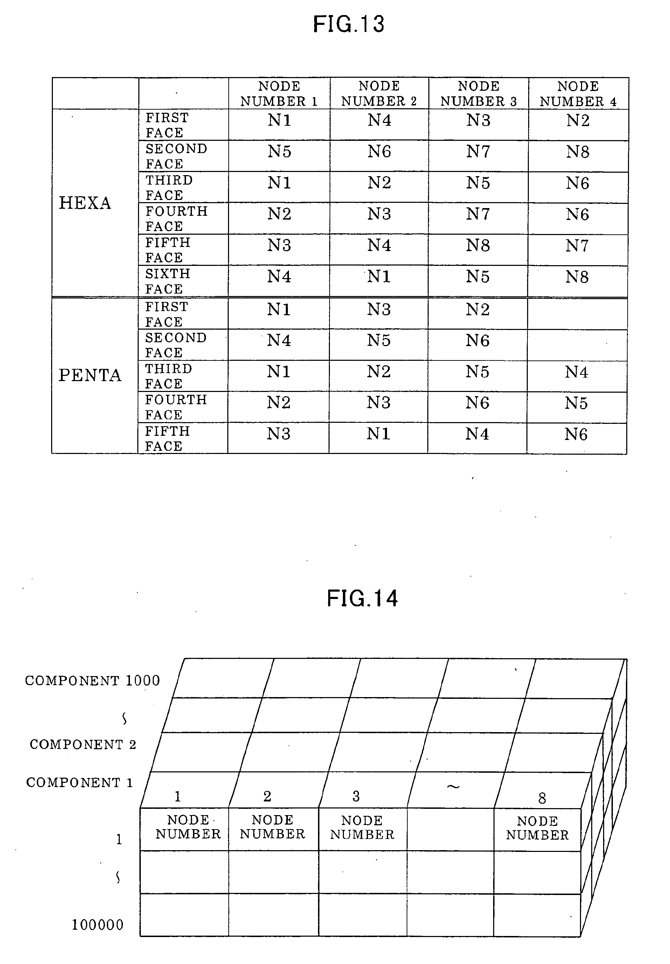

With respect to nodes comprised by face elements, the order is defined in advance. Fig. 11 shows a hexahedron (rectangular parallelepiped); Fig. 12 shows a pentahedron (triangular prism); and Fig. 13 shows an example of a method of defining the order of nodes comprised by each face in the pentahedron and hexahedron. In Fig. 13, it is seen that for example the first face of the hexahedron is defined as comprising the node N1, node N4, node N3, and node N2.

Next, data for a face stored in the array FACEA is read (S2203), and data for a face stored in the array FACE is read (S2204). The array FACE stores data for faces taken to be the outer surfaces of each component at that time. Fig. 14 shows an example of the configuration of a data array in the array FACE.

The face stored in the array FACEA and the faces previously stored in the array. FACE are compared (S2205). Here, as shown in Fig. 10 and Fig. 14, the array FACEA is an 8x6 array, and the array FACE is an 8x100000x1000 data array; all the data in these arrays is compared.

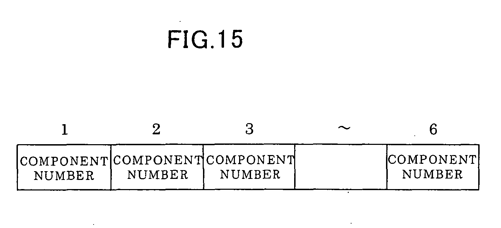

In the above comparison (S2205), if there are three nodes in common between the face element stored in the array FACEA and any of the face elements stored in the array FACE (S2206), the two face elements are taken to be the same face element, and the FACE data for the same face is deleted (S2207). At this time, the component number is stored in the array KT3 (S2208). Fig. 15 Fig. 15 shows an example of the configuration of a data array in the array KT3. The array KT3 is used to check whether the same component described in the array FACE is defined as a separate component, and stores component numbers.

On the other hand, if in the above comparison (S2205) either one node or two nodes are common to the face element stored in the array FACEA and to any of the face elements stored in the array FACE (S2212), the component number in the array FACE is stored in the variable KT1 (S2213). Then, all the face elements stored in the array FACE are compared (S2214), and if there are no three common nodes, the face array FACEA being compared is newly stored in the area of the component number of the array FACE indicated by the variable KT1 (S2215).

If there are no nodes common with any of the face elements stored in the array FACE (S2216, S2217), the data stored in the array FACEA is stored in the array FACE as a new component region (S2218).

Next, after comparisons have been performed for all the data stored in the array FACEA (S2209), a check is performed using the array KT3 to determine, for a single element, whether the component number for the same retrieved face is the same (S2210). If the component number is different, the element is regarded as having been stored as a portion of a separate component despite being a portion of the same component, and the FACE data for the component number indicated by the array KT3 is combined (that is, the data for one component number is stored in the data for the other component number) (S2211). The above processing is repeated for the data of all face elements.

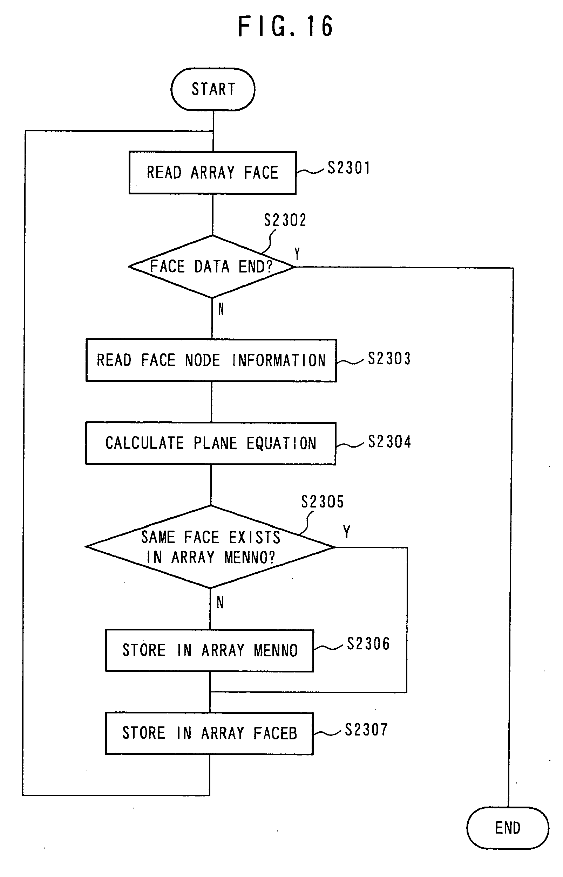

Next, the flowchart of Fig. 16 is used to explain in detail the classification of face groups (S23 in Fig. 5).

First, the data of a single face element stored in the array FACE is read (S2301). Next, the coordinate data of the plurality of nodes comprised by the face element which has been read is retrieved from the array NODE (S2303).

Then, from the node coordinate data retrieved in the above step, the equation of a plane (aX+bY+cZ+d = 0) is determined for the face element (S2304). That is, based on data relating to the surface shape, information is generated relating to the normal vector, directed outward from the object, in an arbitrary region of the outer surface of an arbitrary object among a plurality of objects (vector information generation step).

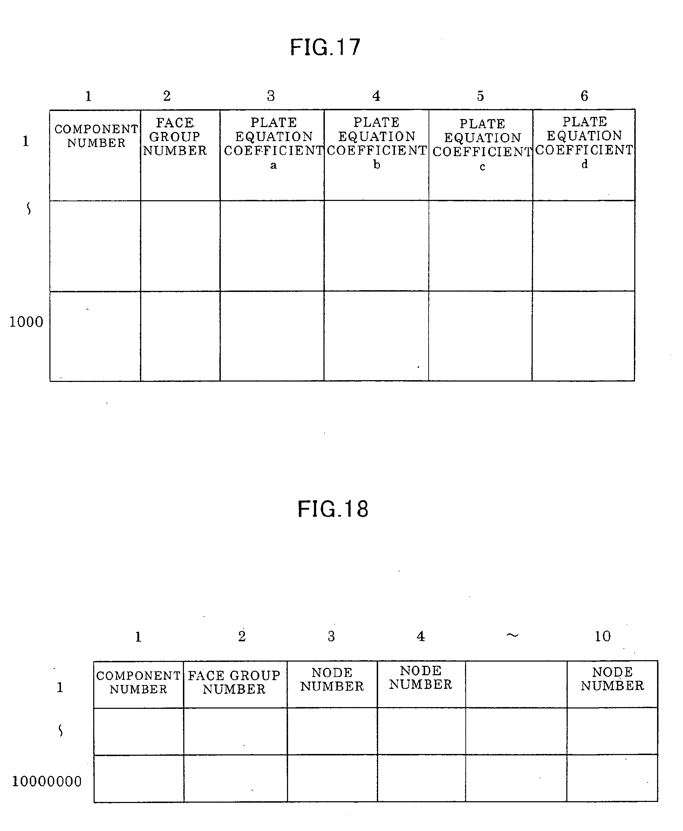

A search is performed of the array MENNO which stores information on the plane equation for each face group (information related to the normal vector) to determine whether the same plane equation has already been stored for the same component (S2305), and if not already stored (No in S2305), a new face group number is assigned, and the plane equation is stored in the array MENNO (S2306). In this aspect, this processing (S2306) is equivalent to a vector information acquisition step. Fig. 17 shows an example of the configuration of a data array in the array MENNO.

Grouping of face elements is performed by storing the data of each face element in the array FACEB for face elements with the same component number and the same face equation (S2307). That is, a plurality of face elements on the same object and existing in the same plane are grouped (grouping step). Fig. 18 shows an example of the configuration of a data array in the array FACEB.

The processing of the above steps (S2301 to S2307) is repeated for all the data stored in the array FACE (S2302).

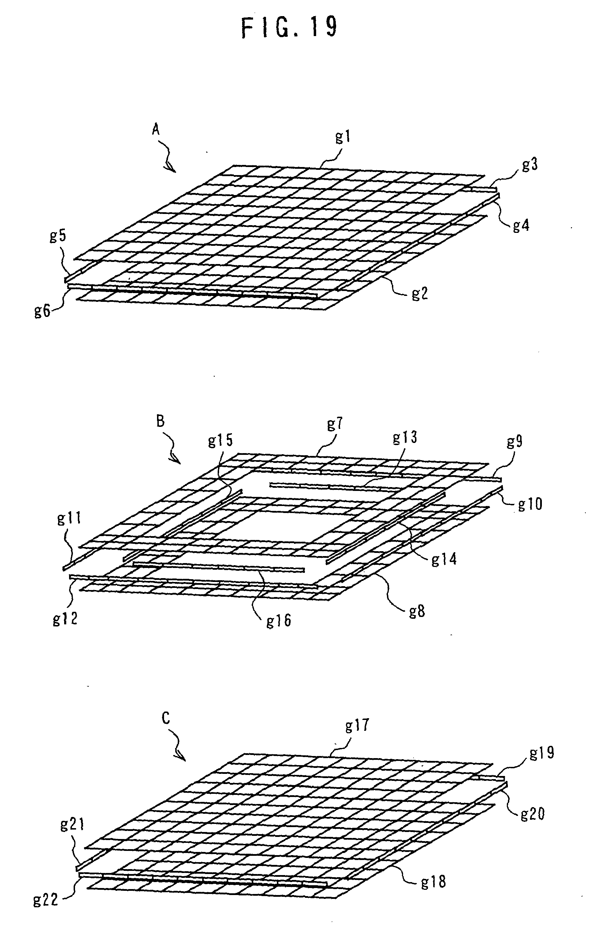

Fig. 19 shows the manner of division into groups of each face element comprised by the components A through C. As shown in the drawing, grouping is performed into the face group number 1 (g1) through the face group number 6 (g6) of component A, the face group number 7 (g7) through the face group number 16 (g16) of component B, and the face group number 17 (g17) through the face group number 22 (g22) of component C.

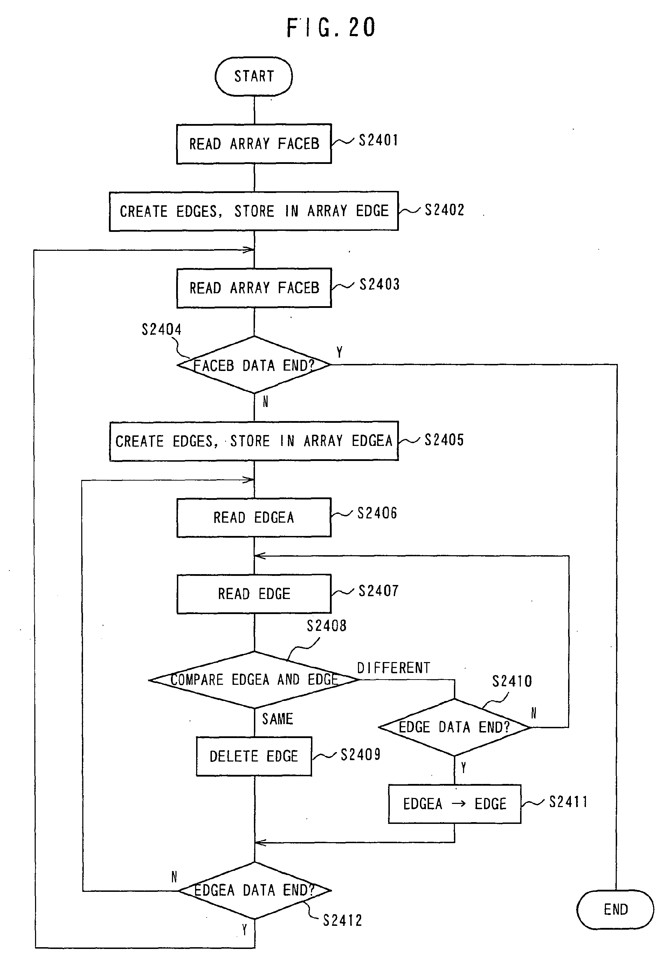

Next, using the flowchart of Fig. 20, the creation of free edges in each of the face groups is explained (S24 in Fig. 5).

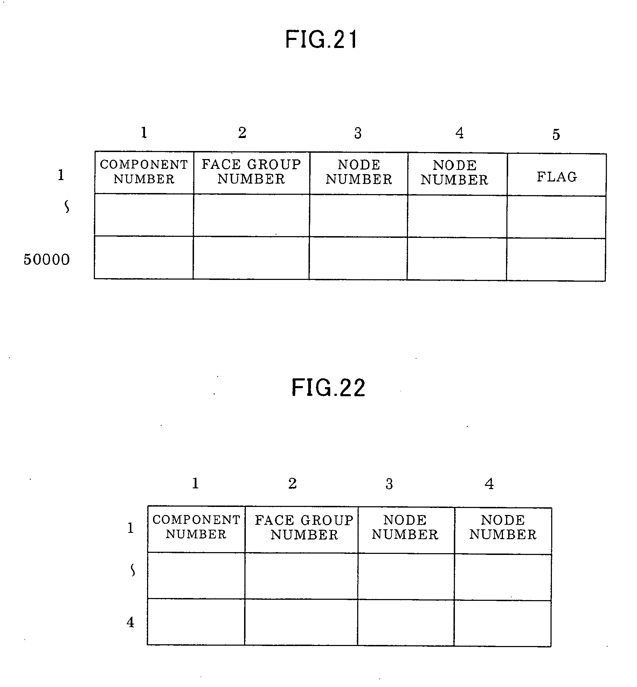

The data for a single face stored in the array FACEB due to the above-described face group classification is read (S2401), edges (outlines of the face) are created for the face which has been read, and data relating to the created edges is stored in the array EDGE (S2402). Fig. 21 shows an example of the configuration of a data array in the array EDGE.

Next, processing is performed to read anew the data of a face group stored in the array FACEB (S2403), and if the data of the face group to be read is still stored in the array FACEB (No in S2404), edges are created for the read face and are stored in the array EDGEA (S2405). If data for the face group to be read has not been stored in the array FACEB (Yes in S2404), processing ends. Fig. 22 shows an example of the configuration of a data array in the array EDGEA.

Next, data relating to edges of the face group stored in the array EDGEA and data relating to the edges of face groups stored in the array EDGE are read (S2406, S2407), and both the data relating to edges is compared (S2408).

If as a result of the above-described comparison the same edge as an edge stored in the array EDGE exists among the edges of the face group stored in the array EDGEA, the data for redundant edges in the array EDGE is deleted (S2409) .

On the other hand, the same edge as an edge stored in the array EDGE does not exist in the edges of the face group stored in the array EDGEA, and if there is no more data for comparison with the array EDGE (Yes in S2410), the data for the edges stored in the array EDGEA is stored in the array EDGE (S2411). If there is data for comparison with the array EDGE (No in S2410), processing returns to the reading of data related to edges of face groups stored in the array EDGE (S2407).

When processing ends for data relating to edges of the face group stored in the array EDGEA (Yes in S2412), processing returns to the reading of data for a face group stored in the array FACEB (S2403). On the other hand, if processing has not ended for data relating to edges of the face group stored in the array EDGEA (No in S2412), processing returns to reading of data for edges stored in the array EDGEA (S2406).

The processing of the above steps (S2403 to S2412) is repeated for all face data, to extract the edges in all face groups (S2404).

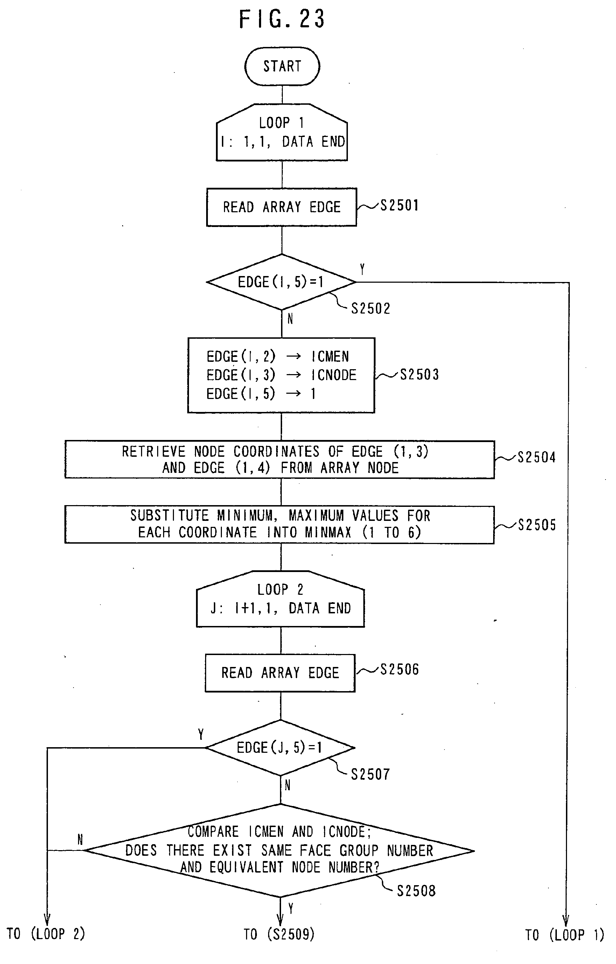

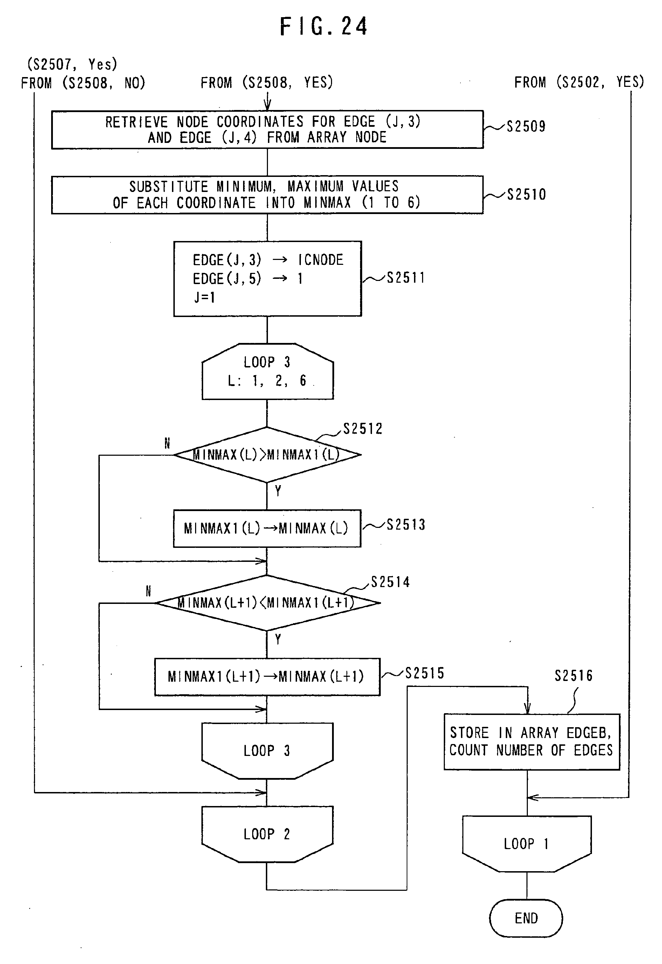

Next, extraction of closed edge regions in the respective face groups (S25 in Fig. 5) is explained, using the flowcharts of Fig. 23 and Fig. 24. Here, for convenience in explanation, a continuous flowchart has been divided into Fig. 23 and Fig. 24.

First, data relating to edges stored in the array EDGE is acquired (S2501). Here, the edge of the acquired data is taken to be the edge E1.

Next, the flag for the data of edge E1 in the array EDGE is checked (S2502). If the flag is not 1 (No in S2502), the face group number is stored in the variable ICMEN and the node numbers are stored in the variable ICNODE, and the flag is set to 1 (S2503).

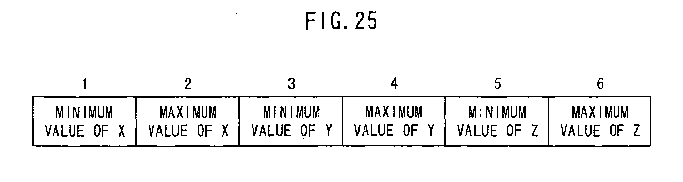

Then, based on node numbers relating to edge E1 in the array EDGE, the node coordinates corresponding to these node numbers are acquired from the array NODE (S2504). The maximum and minimum values of the acquired node coordinates are stored in the array MINMAX (S2505). Fig. 25 shows an example of the configuration of a data array in the array MINMAX.

On the other hand, when the flag is 1 (Yes in S2502), processing returns to the step of acquiring data relating to edges stored in the array EDGE (S2501). Data relating to a new edge stored in the array EDGE is acquired (S2506). The edge for which data is here acquired is taken to be the edge E2.

Next, the fiag of the data for edge E2 in the array EDGE is confirmed (S2507). If the flag is 1 (Yes in S2507), processing returns to the acquisition of data relating to edges stored in the array EDGE (S2506) (loop 2).

If the flag is not 1 (No in S2507), the face group number stored in the variable ICMEN and the node numbers stored in the variable ICNODE in the above step (S2503) are compared with the face group number and node numbers of the edge E2 in the array EDGE, and if as a result there exists an edge with the same face group number and also the same node numbers (Yes in S2508), the node coordinates corresponding to these node numbers are acquired from the array NODE based on the node numbers relating to the edge E2 in the array EDGE (S2509). The minimum and maximum values of the acquired node coordinates are stored in the array MINMAX1 (S2510). The configuration of the data array in the array MINMAX1 is similar to the configuration of the data array in the array MINMAX.

The node numbers stored in the variable ICNODE are updated using the node numbers for edge E2 stored in the array EDGE, the flag is set to 1, and the counter J of the loop 2 is set to 1 (S2511).

The minimum values of the node coordinates of edge E1 and edge E2 are compared, and if the minimum value of edge E2 is smaller than the minimum value of edge E1 (Yes in S2512), the minimum value is updated (S2513).

The maximum values of the node coordinates of edge E1 and edge E2 are compared, and if the maximum value of edge E2 is greater than the maximum value of edge E1 (Yes in S2514), the maximum value is updated (S2515). If the maximum value of edge E2 is smaller than the maximum value of edge E1 (No in S2514), processing returns to the above step (S2512), similar processing is repeated, and the maximum and minimum values of the Y coordinates and Z coordinates are determined (loop 3).

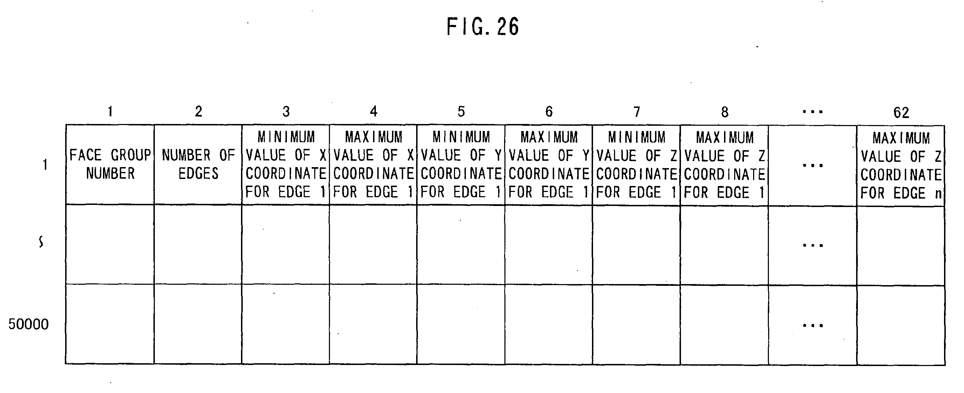

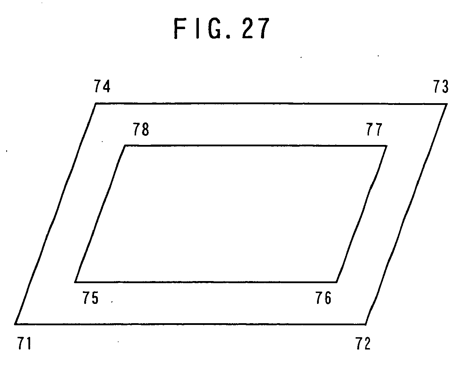

Information relating to the region of the closed edge obtained through the above processing is then stored in the array EDGEB (S2516). This array EDGEB stores information relating to the numbers and regions of closed edges, and using the number of edges, enables the determination of whether holes are formed in the face group. Fig. 26 shows an example of the configuration of a data array in the array EDGEB; Fig. 27 shows an example of a closed edge region, extracted through the above processing. In the same drawing, extracted edges are shown for the face group with number 7 (face group g7 in Fig. 17). It is seen that the face group g7 has two edge regions, one an edge region comprising the nodes 71 to 74, and one an edge region comprising nodes 75 to 78 (that is, with a hole formed).

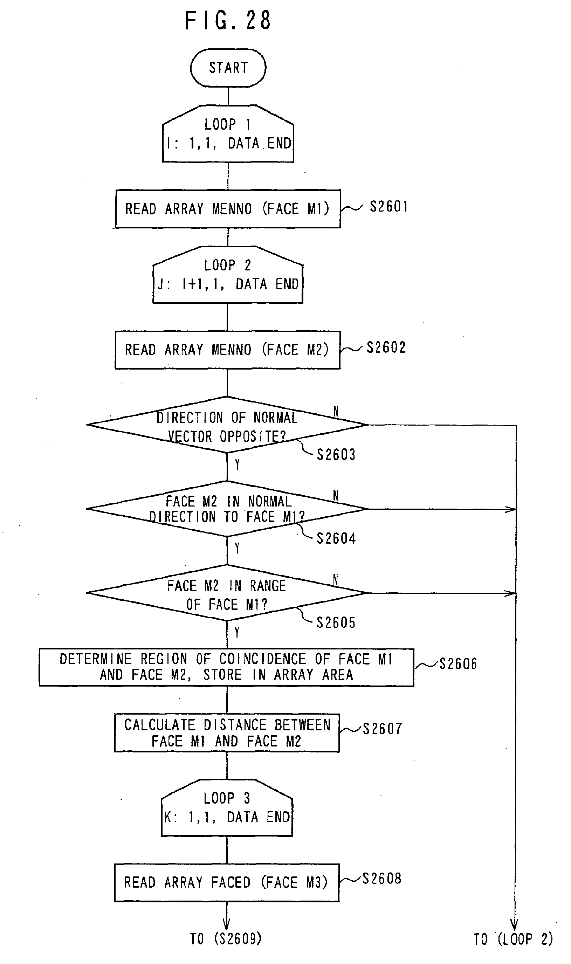

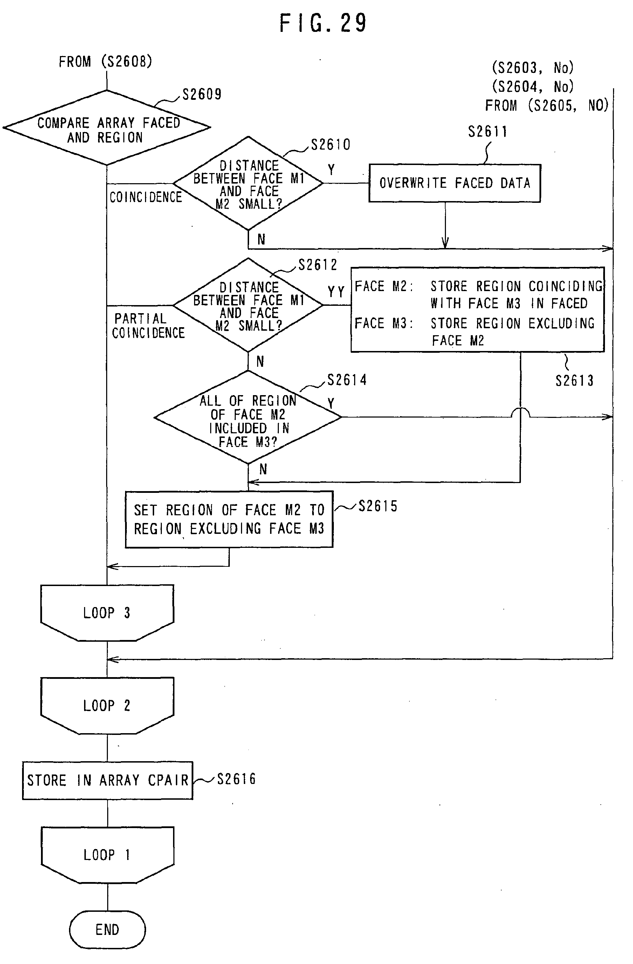

Next, the flowcharts of Fig. 28 and Fig. 29 are used to explain the definition of contact pairs between face groups (S26 in Fig. 5). Here, for convenience in explanation, a continuous flowchart has been divided into Fig. 28 and Fig. 29.

First, the data for one face group is acquired from the array MENNO (S2601). The face group here acquired is designated face M1. Next, the data of a new face group is acquired from the array MENNO (S2602). This acquired face group is designated face M2. Based on the data for the equation of a plane for the faces M1 and M2 acquired from the array MENNO, the angle made by the normal vectors to face M1 and face M2 is determined.

If the directions of the normal vectors are not opposite (No in S2603), processing returns to the acquisition of data for a new face group from the array MENNO (S2602) (loop 2).

If the directions of the normal vectors are opposite (Yes in S2603), then the coordinates of the nodes comprised by face M2 are substituted into the plane equation for face M1, and from the sign of the substituted values, a judgment is made as to whether M2 is in the direction of the normal vector to face M1 (S2604). If face M2 is not in the direction of the normal vector to face M1 (No in S2604), processing returns to acquisition of data for a new face group from the array MENNO (S2602) (loop 2).

If on the other hand face M2 exists in the direction of the normal vector to face M1 (Yes in S2604), a judgment is made, using the data for the edge region stored in array EDGEB, as to whether the region of face M2 is in the range of face M1 (that is, whether a region of face M2 exists at the extension of the normal vector to the entirety of face M1) (S2605).

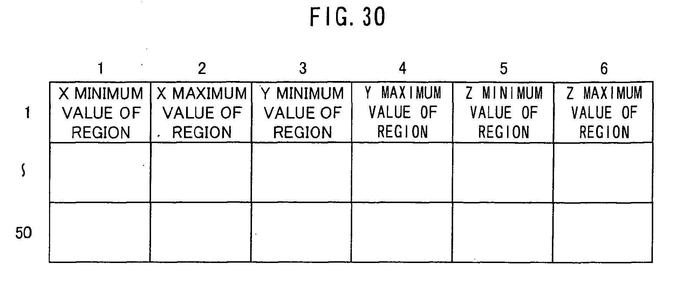

If the region of face M2 is not within the range of face M1 (No in S2605), processing returns to acquisition of data for a new face group from the array MENNO (S2602) (loop 2). If on the other hand the region of face M2 is within the range of face M1 (Yes in S2605), that region of face M1 which is covered by the region of face M2 (that is, the region of face M1 existing at the extension of the normal vector to the entirety of face M2) is stored in the array AREA (S2606). Fig. 30 shows an example of the configuration of a data array in the array AREA.

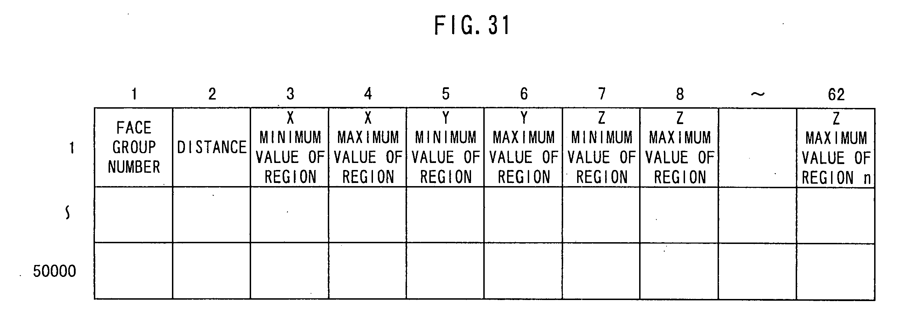

Next, the distance between face M1 and face M2 is calculated (S2607), and the result compared with distances of face M1 from faces regarded as candidates for contact pairs which are already stored in the array FACED (S2608, S2609). Fig. 31 shows an example of the configuration of a data array in the array FACED.

If there is coincidence with a region of a face stored in the array FACED (with the coincident face designated as face M3) (S2609, coincidence), and the distance between face M1 and face M2 is smaller than the distance between face M1 and face M3 (S2610, Yes), then the data of face M3, stored in the array FACED, is overwritten with the data for face M2 (S2611).

If there is partial coincidence of a region covered by face M2 with a region covered by a face stored in the array FACED (where the partially coincident face is designated face M3) (S2609, partial coincidence), and if the distance between face M1 and face M2 is smaller than the distance between face M1 and face M3 (S2612, Yes), then the data of face M2 is newly stored in the array FACED, and with respect to the face M3 of partial region coincidence, the region resulting by subtracting the region covered by face M2 from the region covered by face M3 is taken to be the region covered by face M3, and the data in the array FACED is overwritten (S2613).

If on the other hand the distance between face M1 and face M2 is greater than the distance between face M1 and face M3 (S2612, No), and if the region covered by face M2 is not comprised entirely by the region covered by face M3 (S2614, No), then the region resulting by subtracting the region covered by face M3 from the region covered by face M2 is designated as the region covered by face M2, and the data of face M2 is newly stored in the array FACED (S2615).

If the region covered by face M2 does not coincide at all with the region covered by a face stored in the array FACED (S2609, non-coincidence), processing returns to acquisition of the data of a new face group from the array MENNO (S2602).

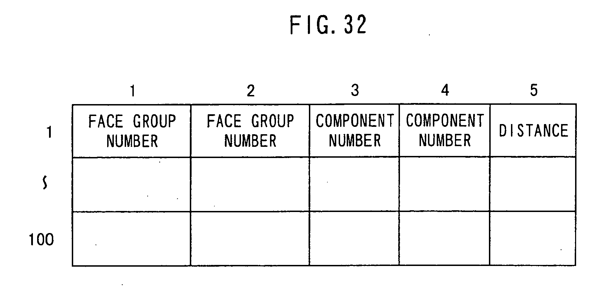

The above-described steps (S2602 to S2615) are repeated for all the data stored in the array MENNO (loop 2), a face which may possibly be in contact with face M1 are determined, and the data for the face is stored in the array CPAIR, which stores information related to contact pairs (S2616). Fig. 32 shows an example of the configuration of a data array in the array CPAIR.

In other words, based on data relating to surface shapes, positional relation information, and information relating to normal vectors, among the regions (groups of face elements) of the outer surface of another object having normal vectors in substantially the opposite direction to a normal vector positioned in the direction of the normal vector in an arbitrary region (group of face elements) of the outer surface of an arbitrary object, in a prescribed positional relation, that region which is closest to the arbitrary region is defined as having the possibility of being in contact with the arbitrary region (contact definition step).

The above processing is performed for all faces (loop 1), and all contact pairs are determined. By thus configuring the process of defining contact pairs, regions in the faces of each face group are identified, and contact definition between a single arbitrary face group and a plurality of face groups becomes possible.

In the definition of contact pairs of this aspect, in order to judge the possibility of contact, the directions of the normal vectors of faces being compared are examined to determine whether they are directed in opposite directions; however, these opposite directions need not be strictly opposite, and for example cases can be included in which the directions of substantially opposing normal vectors are inclined with a range of for example 45° from strictly opposing directions.

Next, output of information relating to defined contact pairs (S27 in Fig. 5) is explained.

Here, information relating to defined contact pairs (the array FACEB and array CPAIR) is output in a data format (analysis input solver format) enabling processing by software which performs finite element analysis (a so-called solver).

A specific data format may for example be represented as follows:

| CONTACT-NODES 2 | | | | |
|---|---|---|---|---|
| 1 | 500651 | 500658 | 500663 | 500651 |

| | | | | | |
|---|---|---|---|---|---|
| 2 | 500743 | | 500763 | 500739 | 500743 |

### CONTACTPAIR 1 2 7

Here "CONTACT-NODES" shows that the face group with face group number 2 has a face element with face number 1, comprising the nodes with node numbers 500651, 500658, 500663, and 500651, and a face element with face number 2, comprising the nodes with node numbers 500743, 500763, 500739, and 500743.

"CONTACTPAIR" shows that the contact pair has contact pair number 1, and comprises a face group with face group number 2 and a face group with face group number 7.

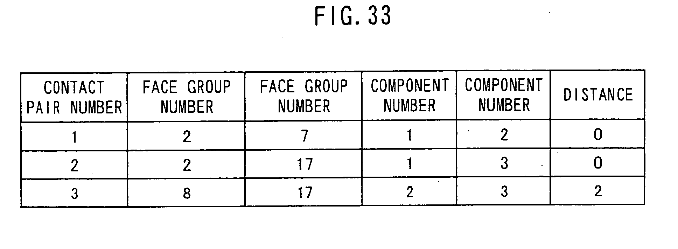

Fig. 33 is a table showing an example of the list output of information related to contact pairs. In the table shown in the drawing, in addition to contact pair numbers and face group numbers, component numbers and the distances between face groups are also shown.

In this aspect, data relating to the rigidity of a plurality of components (rigidity, material, and the like) can be acquired by the rigidity information acquisition portion 17, and used in contact definition by the contact definition portion 14.

Specifically, based on this acquired data relating to rigidity, faces of components with higher rigidity are defined, among the face groups defined as having the possibility of mutual contact, as faces which do not undergo penetration. In this aspect, faces which may undergo penetration are stipulated according to the order of definition of contact faces in the information relating to defined contact pairs, with faces defined in advance taken to be faces for which penetration does not occur (see Fig. 33).

In addition, in this aspect the fact that data relating to surface shapes is input data for analysis, divided into a mesh, can be utilized to define regions of face elements with large mesh sizes, among face groups defined as having the possibility of contact, as faces not undergoing penetration.

In the above-described aspect, information relating to normal vectors used in contact definition is generated by the vector information generation portion 11 based on data relating to the surface shapes of components; but other methods may be employed. For example, when information relating to normal vectors is already comprised by data relating to surface shapes, this information relating to normal vectors comprised in advance may be acquired by the vector information acquisition portion 12.

In addition, in this aspect an example was described in which the shape data 18a, positional relation information 18b and rigidity information 18c were each stored separately in the database 18; but this is not necessary. For example, the surface shape of an object may be stipulated by coordinate values in an absolute coordinate system, or some other configuration may be employed to represent shape data and positional relation information by a single data item.

In this aspect, contact pairs are defined after grouping a plurality of face elements in order to speed processing; but this is not necessary, and definition of contact pairs can also be performed for individual face elements.

A curved surface is also a collection of face elements, and if contact between individual face elements is defined as described above, in addition to contact definition between one plane and another plane, contact definition between a plane and a curved surface, and contact definition between a curved surface and a curved surface, are possible.

In the above aspect, grouping of a plurality of face elements existing in the same plane of the same object is performed; however, the grouping portion for example may perform grouping of face elements orthogonal to prescribed coordinate axes, based on the orthogonal coordinate axis, the coordinates of the face elements, and the directions of normal vectors to the face elements. By thus grouping and handling face elements orthogonal to a coordinate axis, the processing to define contact pairs can be speeded.

In general, face elements described by data relating to the surface shapes of objects often are orthogonal to coordinate axes (for example, any of the coordinate axes in an X-Y-Z coordinate system), and by performing grouping based on orthogonal coordinate axes, the coordinates of the face elements, and the directions of normal vectors to the face elements, processing can be performed to efficiently define contact between face groups with a high possibility of being contact pairs.

In the above aspect, an example was described in which the data relating to surface shapes is input data for analysis, divided into a mesh; but data relating to the surface shape prior to mesh creation (so-called geometrical data) can also be used as the data relating to surface shapes. Geometrical data is data comprising information relating to the edges and surfaces of objects (equivalent to the above-described face groups).

Specifically, in contact definition using geometrical data, surface information is acquired based on geometrical data for each component, free edges are determined based on this surface information, the free edges thus determined are classified into edges in the closed state, and edge regions are determined. Then, based on the surface information and edge regions, contact pairs are defined.

As described above, in this aspect a contact definition method is provided having a shape data acquisition step to acquire data relating to the surface shapes of a plurality of objects; a positional relation information acquisition step to acquire positional relation information relating to prescribed positional relations among the above plurality of objects; a vector information acquisition step to acquire information related to the normal vector in an arbitrary region at the outer surface of an arbitrary object, among the above plurality of objects, directed outward from the object; and, a contact definition step to define, based on the above data relating to surface shapes, positional relation information and information relating to normal vectors, among the regions of the outer surfaces of other objects having normal vectors in substantially the opposite direction of the normal vector positioned in the direction of the above normal vector in an arbitrary region of the outer surface of an arbitrary object in the above prescribed positional relations, the region closest to the arbitrary region as a region which can be in contact with the arbitrary region.

Further, in the above-described contact definition method, it is preferable that the above data relating to the surface shapes of objects comprise data for a plurality of face elements; that the contact definition method have a grouping step of performing grouping of a plurality of face elements existing in the same plane of the same object, based on the above data relating to surface shapes; and that the above contact definition step perform the above definition for each region of the above groups of face elements which have been grouped. Moreover, in the above grouping step, grouping of face elements orthogonal to prescribed coordinate axes can also be performed, based on the orthogonal coordinate axis, the coordinates of face elements, and the directions of normal vectors to the face elements. It is preferable that the above prescribed positional relations be positional relations in a state in which the above plurality of objects are assembled.

In addition, the above-described contact definition method may also have a vector information generation step of generating information relating to a normal vector, directed outward from the object, in an arbitrary region of the outer surface of an arbitrary object among the above plurality of objects, based on the above data relating to surface shapes; and the above vector information acquisition step may be configured so as to acquire information relating to normal vectors generated in the above vector information generation step.

Further, the above-described contact definition method can have a rigidity information acquisition step of acquiring data relating to the rigidity of the above plurality of objects, and the above contact definition step can define a face in the object with high rigidity as a face which does not undergo penetration among the regions defined as having the possibility of contact, based on the above acquired data relating to rigidity.

In the above contact definition method, it is preferable that the above data relating to surface shapes comprise data for a plurality of face elements divided into a mesh, and that the above contact definition step be configured so as to define, among regions defined as having the possibility of contact, a region of the face element with larger mesh size as the face which does not undergo penetration.

Each of the steps in the above-described contact definition method is realized by execution of a contact definition program by a computer (for example, the CPU 19 or the like).

The above-described contact definition program can be stored in recording media readable by a computer (for example, storage portion 1 a or similar), and caused to be executed by a computer serving as a contact definition device. The above computer-readable recording media may be for example a CD-ROM, flexible disk, DVD disc, magneto-optical disc, IC card or other semiconductor storage device, or other transportable storage media, ROM or RAM installed in a computer, magnetic storage device or other fixed storage device, database holding the computer program, another computer or the database thereof, or circuit transmission media.

Specifically, a contact definition program of this aspect is configured to cause a computer to execute a shape data acquisition step to acquire data relating to the surface shapes of a plurality of objects; a positional relation information acquisition step to acquire positional relation information relating to prescribed positional relations among the above plurality of objects; a vector information acquisition step to acquire information related to the normal vector in an arbitrary region at the outer surface of an arbitrary object, among the above plurality of objects, directed outward from the object; and, a contact definition step to define, based on the above data relating to surface shapes, positional relation information and information relating to normal vectors, among the regions of the outer surfaces of other objects having normal vectors in substantially the opposite direction of the normal vector positioned in the direction of the above normal vector in an arbitrary region of the outer surface of an arbitrary object in the above prescribed positional relations, the region closest to the arbitrary region as a region which can be in contact with the arbitrary region.

In the above-described contact definition program, it is preferable that the above data relating to the surface shapes of objects comprise data for a plurality of face elements; that the contact definition program have a grouping step of performing grouping of a plurality of face elements existing in the same plane of the same object, based on the above data relating to surface shapes; and that the above contact definition step perform the above definition for each region of the above groups of face elements which have been grouped. Moreover, in the above grouping step, grouping of face elements orthogonal to prescribed coordinate axes can also be performed, based on the orthogonal coordinate axis, the coordinates of face elements, and the directions of normal vectors to the face elements. It is preferable that the above prescribed positional relations be positional relations in a state in which the above plurality of objects are assembled.

In addition, the above-described contact definition program may also have a vector information generation step of generating information relating to a normal vector, directed outward from the object, in an arbitrary region of the outer surface of an arbitrary object among the above plurality of objects, based on the above data relating to surface shapes; and the above vector information acquisition step may be configured so as to acquire information relating to normal vectors generated in the above vector information generation step.

Further, the above-described contact definition program can have a rigidity information acquisition step of acquiring data relating to the rigidity of the above plurality of objects, and the above contact definition step can define a face in the object with high rigidity as a face which does not undergo penetration among the regions defined as having the possibility of contact, based on the above acquired data relating to rigidity.

In the above contact definition program, it is preferable that the above data relating to surface shapes comprise data for a plurality of face elements divided into a mesh, and that the above contact definition step be configured so as to define, among regions defined as having the possibility of contact, a region of the face element with larger mesh size as the face which does not undergo penetration.

By means of the above aspects, processing to define contact pairs can be performed automatically, careless mistakes can be prevented, and the time required for definition of contact faces and contact pairs can be shortened considerably. Moreover, because faces having the possibility of being in contact are discriminated after identifying regions of face groups, contact definition between a single face group and a plurality of face groups is possible.

Further, by means of the above aspects a contact definition device, contact definition program, and contact definition method can be provided which enable accurate and efficient definition of contact pairs, among a plurality of objects, having the possibility of mutual contact. The invention may be applied, for example, to computer-aided design of products.

## Claims

1. A contact definition device, comprising:
a shape data acquisition portion, which acquires data relating to the surface shapes of a plurality of objects;
a positional relation information acquisition portion, which acquires positional relation information relating to prescribed positional relations among said plurality of objects;
a vector information acquisition portion, which acquires information related to the normal vector in an arbitrary region at the outer surface of an arbitrary object among said plurality of objects, directed outward from the object; and,
a contact definition portion which defines, based on said data relating to surface shapes, positional relation information and information relating to normal vectors, a region closest to the arbitrary region among the regions of the outer surfaces of other objects having normal vectors in substantially the opposite direction of the normal vector positioned in the direction of said normal vector in the arbitrary region of the outer surface of the arbitrary object in said prescribed positional relations, as a region which can be in contact with the arbitrary region.

2. The contact definition device according to Claim 1, wherein
said data relating to the surface shapes of objects comprises data for a plurality of face elements;
said contact definition device has a grouping portion which groups a plurality of face elements existing in the same plane on the same object based on said data relating to surface shapes; and
said contact definition portion performs said definition for each region of said groups of grouped face elements.

3. The contact definition device according to Claim 1 or 2, wherein said prescribed positional relation is a positional relation in the state in which said plurality of objects are assembled.

4. The contact definition device according to Claim 1,2, or 3, further comprising a vector information generation portion which generates information relating to normal vector in an arbitrary region of the outer surface of an arbitrary object among said plurality of objects, directed outward from the object, based on said data relating to surface shapes, and wherein said vector information acquisition portion acquires information related to normal vector generated by said vector information generation portion.

5. The contact definition device according to Claim 1,2,3, or 4, further comprising a rigidity information acquisition portion which acquires data relating to the rigidity of said plurality of objects, and wherein said contact definition portion defines a region of an object with higher rigidity, among regions defined as having the possibility of mutual contact, as the face which does not undergo penetration.

6. The contact definition device according to any of Claim 1 to 5,wherein said data relating to surface shapes comprises data of a plurality of face elements divided into a mesh, and said contact definition portion defines a region of the face element with a larger mesh size, among regions defined as having the possibility of mutual contact, as the face which does not undergo penetration.

7. A contact definition program, which causes a computer to execute:
a shape data acquisition step of acquiring data relating to the surface shapes of a plurality of objects;
a positional relation information acquisition step of acquiring positional relation information relating to prescribed positional relations among said plurality of objects;
a vector information acquisition step of acquiring information related to the normal vector in an arbitrary region at the outer surface of an arbitrary object among said plurality of objects, directed outward from the object; and,
a contact definition step of defining, based on said data relating to surface shapes, positional relation information and information relating to normal vectors, a region closest to the arbitrary region among the regions of the outer surfaces of other objects having normal vectors in substantially the opposite direction of the normal vector positioned in the direction of said normal vector in the arbitrary region of the outer surface of the arbitrary object in said prescribed positional relations, as a region which can be in contact with the arbitrary region.

8. The contact definition program according to Claim 7, wherein said data relating to the surface shapes of objects comprises data for a plurality of face elements;
said contact definition program further comprises a grouping step of grouping a plurality of face elements existing in the same plane on the same object based on said data relating to surface shapes; and
said contact definition step performs said definition for each region of said groups of grouped face elements.

9. The contact definition program according to Claim 7 or 8, wherein said prescribed positional relation is a positional relation in the state in which said plurality of objects are assembled.

10. The contact definition program according to Claim 7, 8, or 9, further comprising a vector information generation step of generating information relating to a normal vector in an arbitrary region of the outer surface of an arbitrary object among said plurality of objects, directed outward from the object, based on said data relating to surface shapes, and wherein said vector information acquisition step acquires information related to the normal vector generated by said vector information generation step.

11. The contact definition program according to any of Claims 7 to 10, further comprising a rigidity information acquisition step of acquiring data relating to the rigidity of said plurality of objects, and wherein said contact definition step defines a a face of an object with higher rigidity, among regions defined as having the possibility of mutual contact, as the face which does not undergo penetration.

12. The contact definition program according to any of Claims 7 to 11, wherein said data relating to surface shapes comprises data of a plurality of face elements divided into a mesh, and said contact definition step defines the region of the face element with a larger mesh size, among regions defined as having the possibility of mutual contact, as the face which does not undergo penetration.

13. A contact definition method, comprising:
a shape data acquisition step of acquiring data relating to the surface shapes of a plurality of objects;
a positional relation information acquisition step of acquiring positional relation information relating to prescribed positional relations among said plurality of objects;
a vector information acquisition step of acquiring information related to a normal vector in an arbitrary region at the outer surface of an arbitrary object among said plurality of objects, directed outward from the object; and,
a contact definition step of defining, based on said data relating to surface shapes, positional relation information and information relating to normal vectors, a region closest to the arbitrary region among the regions of the outer surfaces of other objects having normal vectors in substantially the opposite direction of the normal vector positioned in the direction of said normal vector in the arbitrary region of the outer surface of the arbitrary object in said prescribed positional relations, as a region which can be in contact with the arbitrary region.

14. The contact definition method according to Claim 13, wherein said data relating to the surface shapes of objects comprises data for a plurality of face elements;
said contact definition method comprises a grouping step of grouping a plurality of face elements existing in the same plane on the same object based on said data relating to surface shapes; and
said contact definition step performs said definition for each region of said groups of grouped face elements.

15. The contact definition method according to Claim 13 or 14, wherein said prescribed positional relation is a positional relation in the state in which said plurality of objects are assembled.

16. The contact definition method according to Claim 13,14, or 15, further comprising a vector information generation step of generating information relating to a normal vector in an arbitrary region of the outer surface of an arbitrary object among said plurality of objects, directed outward from the object, based on said data relating to surface shapes, and wherein said vector information acquisition step acquires information related to the normal vector generated by said vector information generation step.

17. The contact definition method according to any of Claims 13 to 16, further comprising a rigidity information acquisition step of acquiring data relating to the rigidity of said plurality of objects, and wherein said contact definition step defines a face of an object with higher rigidity, among regions defined as having the possibility of mutual contact, as the face which does not undergo penetration.

18. The contact definition method according to any of Claims 13 to 17, wherein said data relating to surface shapes comprises data of a plurality of face elements divided into a mesh, and said contact definition step defines the region of the face element with a larger mesh size, among regions defined as having the possibility of mutual contact, as the face which does not undergo penetration.
